# EUROPEAN PATENT APPLICATION

(11) **EP 4 439 896 A1**
(43) Date of publication of application: **02.10.2024**
(21) Application number: 23166019.2
(22) Date of filing: 31.03.2023
(51) Int. Cl.: H02H 3/04, H02H 7/00, H02H 9/02, H03K 17/082

(54) **CONTROL OF A SEMICONDUCTOR COMPONENT OF A CURRENT LIMITER**

(71) Applicant: ABB SCHWEIZ AG, 5400 Baden (CH)
(72) Inventor: HANSSON, Ulf, 722 10 Västerås (SE); WIKMAN, Tony, 723 53 Västerås (SE); BERGQVIST, Joakim, 811 98 Österfärnebo (SE)
(74) Representative: Kransell & Wennborg KB

(57) **Abstract**

The present invention relates to a method for controlling a semiconductor component (112, 310) of an electric current limiter circuit (104, 304) for a power supply, the controllable semiconductor component to be connected to a load (106) at the output (108) of the current limiter circuit as a current limiting component, the method comprises: sampling (S102), by a control unit (114), measurements of a voltage across the controllable semiconductor component at a sampling frequency, calculating (S104), by the control unit, an energy dissipated in the controllable semiconductor component during a time duration based on the sampled voltage and an electric current value, and controlling (S106), by the control unit, the controllable semiconductor component to allow for recovery time durations (Tr) to maintain a temperature of the controllable semiconductor component below a predetermined limit.

## Description

### Field of the Invention

The present invention relates to a method for controlling a semiconductor component of an electric current limiter circuit of a power supply. The present invention further relates to a control unit for executing the method, a computer program product, and to a corresponding electric circuit.

### Background

Protection circuits such as electric current limiters are employed to limit an electric current that is delivered to a load so that the power supply is protected in case of short circuit or other overloads. The limiting element of electric current limiters may be exposed to high currents which may risk overheating.

Electric current limiters and their limiting elements typically includes custom made and designed circuits for the specific load case and often include expensive integrated circuits.

It would be desirable to reduce the complexity of protection circuits to allow a broader range of components regardless of the load case and consequently also reduce the cost of protection circuits.

### Summary

In view of the above-mentioned and other drawbacks of the prior art, it is an object of the present invention to provide a method for controlling a semiconductor component of an electric current limiter circuit that at least partly alleviates the deficiencies with prior art.

According to a first aspect of the invention, there is provided a method for controlling a semiconductor component of an electric current limiter circuit for a power supply, the controllable semiconductor component to be connected to a load at the output of the current limiter circuit as a current limiting component, the method comprises: sampling, by a control unit, measurements of a voltage across the controllable semiconductor component or across the current limiter at a sampling frequency, calculating, by the control unit, an energy dissipated in the controllable semiconductor component during a time duration based on the sampled voltage and an electric current value, and controlling, by the control unit, the controllable semiconductor component to allow for recovery time durations to maintain a temperature of the controllable semiconductor component below a predetermined limit.

The present invention is at least partly based on the realization to actively control the semiconductor component with recovery time durations so that the temperature, or dissipated energy, in the semiconductor component is kept sufficiently low and within thermal specifications. Using this control, the energy dissipated in the semiconductor component is continuously, with a sampling rate, calculated so that the semiconductor component can be timely disconnected from the load to allow for recovery so that the average dissipated energy over a cycle is kept low. To be kept low is interpreted such that the temperature of the semiconductor component is below the predetermined limit which may be given by thermal specifications of the semiconductor component.

The voltage measurement that is sampled may be measured across be across the semiconductor component. Alternatively, the voltage measurement that is sampled may be measured across the electric current limiter.

The method may be implemented using firmware running on a control unit controlling the hardware semiconductor component. This control may be implemented in a wide range of loads and protection circuits.

In embodiments, controlling the controllable semiconductor component may comprise switching off, by the control unit, the controllable semiconductor component for a recovery time duration. That is, for a given recovery time duration, the semiconductor component does not allow the transfer electric current from the power supply to the load. Thereby, no, or very little, energy is dissipated in the semiconductor component.

In embodiments, controlling the controllable semiconductor component may comprise switching on, by the control unit, the controllable semiconductor component once the recovery time duration has lapsed. Thus, once the semiconductor component has allowed to cool down some, the semiconductor component is switched back on to proceed operation and transfer of electric current to the load. Switching on and off the semiconductor component may be continuously performed with a duty cycle.

In embodiments, the method may comprise monitoring the calculated dissipated energy, and when the calculated dissipated energy exceeds a threshold, controlling the semiconductor component to allow for a recovery time duration. The dissipated energy is relatively straight forward to calculate as the time integral of dissipated power given by the product of electric current and voltage and thus provides for a convenient measure to determine when to allow the semiconductor component to recover

In embodiments, the threshold with which the calculated dissipated energy is compared may be adjustable by the control unit. Thus, the threshold may be adapted to better fit environmental circumstances, ambient temperature, load cases, etc.

In embodiments, the method may comprise determining a voltage drop across the current limiter, and when the voltage drop exceeds an allowed voltage limit, calculating, the energy dissipated and controlling the controllable semiconductor component. That is, the method may be initiated once the voltage drop exceeds the limit which may indicate an electric fault such as a short circuit or overload.

In embodiments, the recovery time duration is such that a duty cycle of the controllable semiconductor component is less than 10%, or less than or equal to 5%. The duty cycle is calculated to make sure that the average dissipated energy over a time window, i.e., one period of the operation of the semiconductor component, is below the threshold which is adapted to ensure that the semiconductor component does not overheat. For example, if the semiconductor component is operating at the electric current limit of the electric current limiter, the semiconductor component may be allowed to be on for a time duration until the semiconductor component is given a recovery time duration. The recovery time duration may be in the range of about 10-1000 times the time duration at the electric current limit, such as at least 10 times the time duration at the electric current limit, or 20 times time duration at the electric current limit, or even or 40 times time duration at the electric current limit. In some possible embodiments, the recovery time duration may be up to 500 times the time duration at the electric current limit or even 1000 times the time duration at the electric current limit.

In preferred embodiments, the electric current value may be a predetermined value. The predetermined electric current value may for example be a rated maximum current of the electric current limiter.

In embodiments, the method may comprise sampling measurements of an electric current through the semiconductor component to obtain electric current values. That is, the electric current value may be a measured electric current.

In embodiments, the controllable semiconductor component may be a transistor. The transistor may be of various kinds such as a field effect transistor (FET), metal-oxide-semiconductor field-effect transistor (MOSFET), junction field effect transistor (JFET), and bipolar junction transistor (BJT).

The current limiter may be configured for a maximum electric current in the range of about 50 mA to about 5 A, such as for example about 5 A, about 3 A, preferably about 1 A, more preferably about 700 mA, more preferably less about 100 mA, or about 50 mA, to be supplied to the load.

Sampling and calculating the dissipated energy may be performed at a rate within a range of 100 Hz - 5 kHz, such as a 1 kHz repetition rate.

In a second aspect of the present invention, there is provided an electric circuit comprising: a power supply input for receiving electric power to be delivered to a load; a current limiter electrically connected between the power supply and the load, the current limiter comprises a controllable semiconductor component connectable to the load as a current limiting component; a control unit configured to: sample measurements of a voltage across the controllable semiconductor component at a sampling frequency, calculate an energy dissipated in the controllable semiconductor component during a time duration based on the sampled voltage and an electric current value, and control the controllable semiconductor component to allow for recovery time durations to maintain a temperature of the controllable semiconductor component below a predetermined limit.

In one embodiment, the controllable semiconductor component may be a transistor.

Further effects and features of the second aspect of the invention are largely analogous to those described above in connection with the first aspect of the invention.

There is further provided a computer program product comprising a non-transitory computer readable medium having stored thereon computer program means for executing the method.

The is further provided a control unit configured to execute the method.

Further features of, and advantages with, the present invention will become apparent when studying the appended claims and the following description. The skilled person realizes that different features of the present invention may be combined to create embodiments other than those described in the following, without departing from the scope of the present invention.

### Brief Description of the Drawings

These and other aspects of the present invention will now be described in more detail, with reference to the appended drawings showing an example embodiment of the invention, wherein:
Fig. 1 is a block diagram of an example electric circuit according to embodiments of the invention;
Fig. 2 is a flow-chart of method steps according to embodiments of the invention;
Fig. 3 is a block diagram of an example electric circuit according to embodiments of the invention;
Fig. 4 is a flow-chart of method steps according to embodiments of the invention; and
Fig. 5 is a graph of a control signal for periodic switching on/off of a semiconductor component according to embodiments of the invention.

### Detailed Description of Example Embodiments

In the present detailed description, various embodiments of the present invention are herein described with reference to specific implementations. In describing embodiments, specific terminology is employed for the sake of clarity. However, the invention is not intended to be limited to the specific terminology so selected. While specific exemplary embodiments are discussed, it should be understood that this is done for illustration purposes only. A person skilled in the relevant art will recognize that other components and configurations can be used without parting from the scope of the invention.

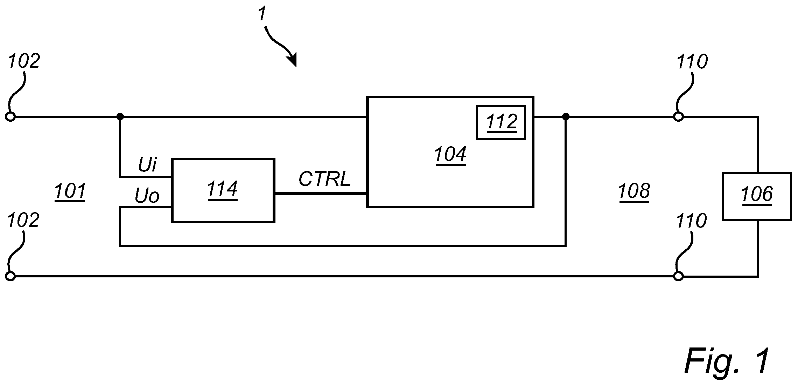

Fig. 1 illustrates an electric circuit 1 according to one embodiment. The electric circuit comprises a power supply input 101 for receiving electric power to be delivered to a load. The input is connectable to a power supply via suitable electrical connection ports 102.

The electric circuit 1 comprises a current limiter 104 electrically connected between the power supply input 101 and a load 106 connected to the output 108 at electrical ports 110. The current limiter 104 comprises a controllable semiconductor component 112 connectable to the load 106 as an electric current limiting component. The electric current limiter 104 is configured to limit an electric current that is delivered to the load 106 so that the power supply at the input 101 is protected in case of short circuit or other overloads or faults.

The electric circuit 1 comprises a control unit 114, such as a microcontroller that can receive voltage measurements, Ui, Uo, from sensors of the circuit 1, but also provide control signals CTRL to the current limiter 104 to for example control the operation of the semiconductor element 112.

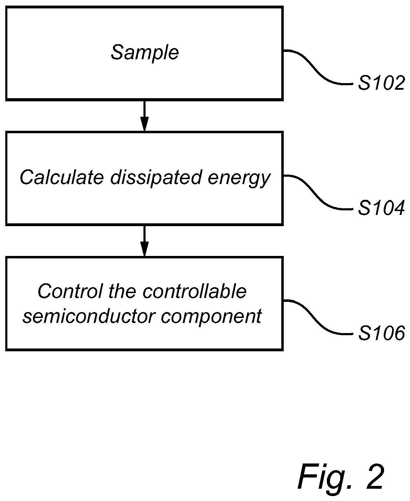

With reference also to the flow chart in fig. 2. The control unit 114 is configured to sample, in step S102, measurements of a voltage, Ui-Uo, across the controllable semiconductor component and/or across the electric current limiter 104 at a sampling frequency. The sampling frequency may be in the range of 100 Hz to about 5 kHz, such as at about 1 kHz.

In step S104, calculate, by the control unit 114, an energy dissipated in the controllable semiconductor component 112 during a time duration based on the sampled voltage and an electric current value. Preferably, the electric current value is a predetermined value set by an electric current rating of the electric current limiter 104. For example, the predetermined electric current value may be 50 mA, 100mA, 500mA, 1A, 3A, 3.3A, 4A, 5A, to mention some examples. It is also envisaged that the electric current value may be a sampled measurement of an electric current through the semiconductor component.

In step S106, controlling, by the control unit 114 by transmitting the control signals CTRL, the controllable semiconductor component 112 to allow for recovery time durations to maintain a temperature of the controllable semiconductor component 112 below a predetermined limit. The predetermined limit may be according to thermal specifications of the controllable semiconductor component 112.

Controlling the controllable semiconductor component may comprise switching off, by the control unit 114, the controllable semiconductor component 310 for a recovery time duration by setting the CTRL signal to OFF.

Subsequently, the control unit 114 may switch on by setting the CTRL signal to ON, the controllable semiconductor component 310 once the recovery time duration has lapsed.

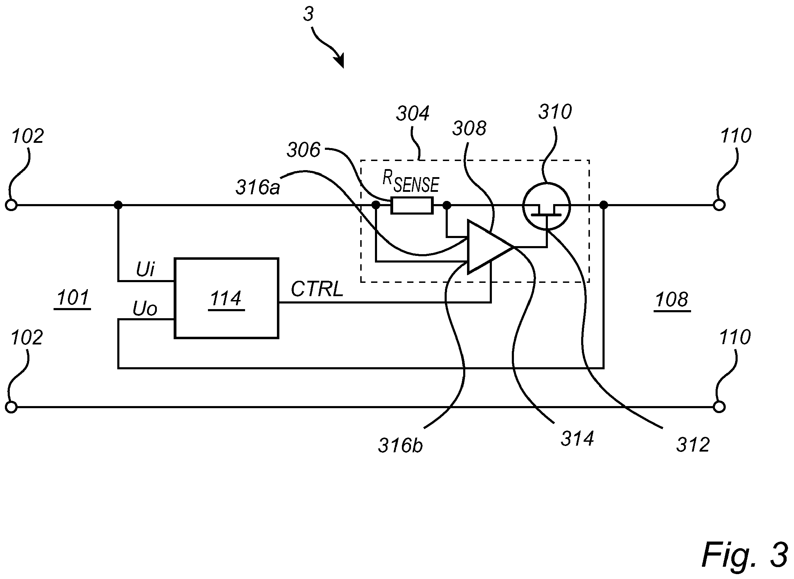

Fig. 3 is a block diagram of an electric circuit 3 according to an example embodiment. The electric circuit 3 comprises the input port 101, the output port 108, the control unit 114 as described above.

In addition, the electric current limiter 304 comprises a sensing resistor 306, a regulating circuit 308, and a controllable semiconductor component in the form of a transistor 310. The gate 312 of the transistor 310 is connected to an output port 314 of the regulating circuit 308.

Inputs 316a-b of the regulating circuit 308 are connected across the sensing resistor 306. The regulating circuit 308 is configured to sense a voltage across the sensing resistor 306 and to accordingly control the transistor via its gate 312 to limit the electric current through the transistor 310 according to a maximum allowed electric current. The regulating circuit 308 may be provided in various forms and comprise electrical components including operational amplifiers or bipolar transistors, and other components for regulating the transistor current.

When control signal CTRL provided by the control unit 114 indicates OFF, e.g., when CTRL=0, or is low, the regulating circuit 308 is disabled. When the regulating circuit 308 receives OFF, the transistor 310 is switched off and does not allow electric current to pass to the output 108. The control signal CTRL may be considered an enable-disable signal that overrides the normal function of the regulating circuit 308. When the regulating circuit 308 receives CTRL=ON, the transistor 310 is operative and regulates the maximum electric current that can pass to the output 108.

Note that the circuit 3 is a schematic drawing and may comprise additional electrical components.

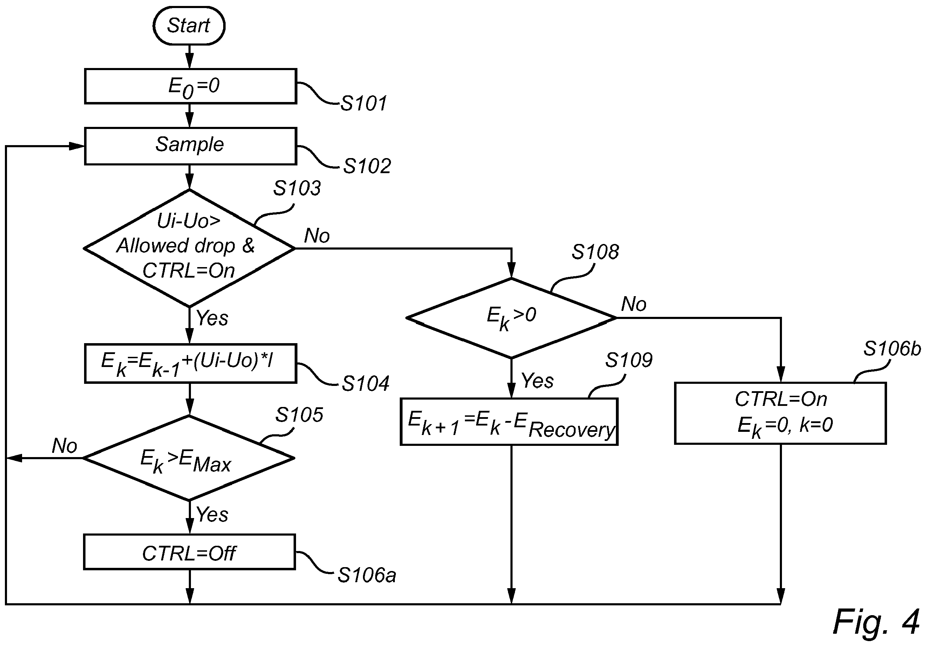

Now with reference to the flow-chart in fig. 4 illustrating steps according to one possible embodiment.

When the method in fig. 4 is initiated, an energy dissipation parameter E is set to zero in step S101.

In step S102, the control unit 114 samples a voltage drop (Ui-Uo) across the electric current limiter 304. If the control unit 114 determines, in step S103 that the voltage drop exceeds an allowed voltage limit and the CTRL signal is presently set to ON, that is, the transistor 310 is powered on and operative, e.g., switched on, the dissipated energy is calculated in step S104 as the product between the voltage drop Ui-Uo and the electric current value I.

The allowed voltage limit is such that it exceeds the voltage drop under normal operation with a set margin. If a fault is detected, such as a short circuit in the load, the voltage drop (Ui-Uo) across the electric current limiter 304 increases so that it exceeds the allowed voltage limit.

The calculated dissipated energy (Ui-Uo)*I in step S104 is added to the energy dissipation parameter Ek. In other words, the calculated energy from each iteration is accumulated in the energy dissipation parameter E. If control unit 114 determines that the accumulated dissipated energy, that is, the present energy parameter Ek exceeds an energy threshold E_{Max} in step S105, the control unit 114 controls the semiconductor component 310 to allow for a recovery time duration. For this, the control unit 114 sets the control signal CTRL to OFF, i.e., a low signal in step S106a. The method returns to step S102.

If the accumulated dissipated energy, that is, the present energy parameter Ek does not exceed the energy threshold E_{Max} in step S105, a new sample is acquired in step S102. Assuming that the voltage drop is still above the allowed limit, a further calculation of dissipated energy is performed in step S104, and the present accumulated dissipated energy parameter E is again compared with the energy threshold E_{Max} in step S105. As discussed above, once a present accumulated energy parameter Ek exceeds the energy threshold E_{Max} in step S105, the control signal CTRL is set to OFF in the control step S106a, comprising to switch off the transistor 310.

Once returned to step S102, if the outcome is negative in subsequent step S103, e.g. since the control signal CTRL is set to OFF, the energy dissipation parameter Ek representing the accumulated dissipated energy is compared with zero in step S108.

If the energy dissipation parameter E exceeds zero in step S108, the energy dissipation parameter E is reduced by a recovery energy amount, E_{Recovery} in step S109, e.g., the new the energy dissipation parameter Ek+1=EkE_{Recovery}. The recovery energy amount E_{Recovery} may be determined from empirical or theoretical calculations.

Once the present energy dissipation parameter Ek is determined to be equal to or below zero in step S108, the control unit 114 controls the transistor 310 in step S106b. In step S106b, the control unit 114 switches on the transistor 310 by setting the control signal to ON, that is, by providing a high signal. The energy dissipation parameter E is reset at zero, thus, the method returns to step S101.

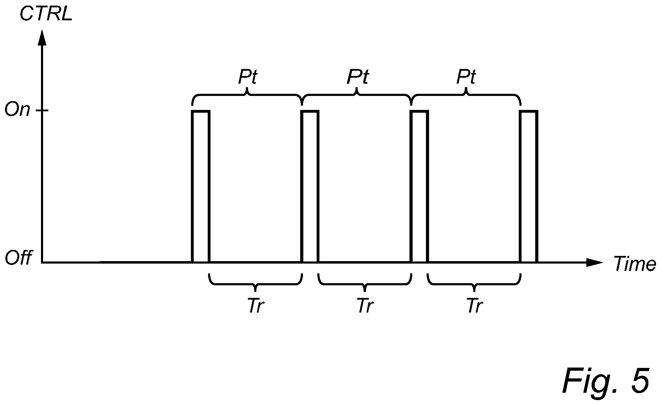

Fig. 5 illustrates a control signal CTRL as a function of time to illustrate that the control of the transistor 310 may be periodically performed. The recovery time duration Tr is preferably such that the duty cycle is less than 10%, or less than or equal to 5%. The recovery time duration Tr is at least 90% of a period time Pt of the controllable semiconductor component 310. The recovery time duration Tr may be calculated as a factor multiplied by the time duration which the transistor is allowed to operate at its electric current limit, e.g. when the CTRL indicates ON and the operation is at the rated maximum power or electric current of the semiconductor component. Such factor may be in the range 10-1000, such as 20, 30, 40, 500, or even 1000. The recovery time duration, or duration, Tr, is adapted so that the average energy dissipated over one period time Pt is sufficiently low to not cause overheating of the transistor 310. During recovery, the CTRL signal indicated OFF.

There is further provided a computer program product comprising a computer readable medium having stored thereon computer program means for executing the method according to any one or the herein described embodiments. The non-transitory computer readable medium is preferably accessible by the control unit 114, provided as a microcontroller or microprocessor.

A control unit may include a microprocessor, microcontroller, programmable digital signal processor or another programmable device. The control unit may also, or instead, include an application specific integrated circuit, a programmable gate array or programmable array logic, a programmable logic device, or a digital signal processor. Where the control unit includes a programmable device such as the microprocessor, microcontroller or programmable digital signal processor mentioned above, the processor may further include computer executable code that controls operation of the programmable device.

In one or more examples, the functions described may be implemented in hardware, software, firmware, or any combination thereof. If implemented in software, the functions may be stored on or transmitted over as one or more instructions or code on a computer-readable medium and executed by a hardware-based processing unit. Computer-readable media may include computer-readable storage media, which correspond to tangible media such as data storage media, or communication media including any media that facilitate the transfer of a computer program from one place to another, e.g., according to a communication protocol. In this manner, computer-readable media generally may correspond to (1) tangible computer-readable storage media which are non-transitory or (2) a communication media such as signal or carrier waves. Data storage media may be any available media that can be accessed by one or more computers or one or more processors to retrieve instructions, code and/or data structures for implementation of the techniques described in this disclosure. A computer program product may include a computer-readable medium.

By way of example, and not limitation, such computer-readable storage media can comprise RAM, ROM, EEPROM, CD-ROM or other optical disk storage, magnetic disk storage, or other magnetic storage devices, flash memory, or any other medium that can be used to store desired program code in the form of instructions or data structures and that can be accessed by a computer.

Even though the invention has been described with reference to specific exemplifying embodiments thereof, many different alterations, modifications and the like will become apparent for those skilled in the art.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage.

## Claims

1. A method for controlling a semiconductor component (112, 310) of an electric current limiter circuit (104, 304) for a power supply, the controllable semiconductor component to be connected to a load (106) at the output (108) of the current limiter circuit as a current limiting component, the method comprises:
sampling (S102), by a control unit (114), measurements of a voltage across the controllable semiconductor component or across the current limiter at a sampling frequency,
calculating (S104), by the control unit, an energy dissipated in the controllable semiconductor component during a time duration based on the sampled voltage and an electric current value, and
controlling (S106), by the control unit, the controllable semiconductor component to allow for recovery time durations (Tr) to maintain a temperature of the controllable semiconductor component below a predetermined limit.

2. The method according to claim 1, wherein controlling the controllable semiconductor component comprises:
switching off (S106a), by the control unit, the controllable semiconductor component for a recovery time duration.

3. The method according to claim 2, wherein controlling the controllable semiconductor component comprises:
switching on (S106b), by the control unit, the controllable semiconductor component once the recovery time duration has lapsed.

4. The method according to any one of the preceding claims, comprising:
monitoring (S105) the calculated dissipated energy, and
when the calculated dissipated energy exceeds a threshold (E_{Max}), controlling the semiconductor component to allow for a recovery time duration.

5. The method according to claim 4, wherein the threshold is adjustable by the control unit.

6. The method according to any one of the preceding claims, comprising:
determining (S103) a voltage drop across the current limiter, and
when the voltage drop exceeds an allowed voltage limit, calculating, the energy dissipated and controlling the controllable semiconductor component.

7. The method according to any one of the preceding claims, wherein the recovery time duration is such that a duty cycle of the controllable semiconductor component is less than 10%, or less than or equal to 5%.

8. The method according to any one of the preceding claims, wherein the electric current value is a predetermined value.

9. The method according to claim 8, wherein the predetermined value is a rated maximum electrical current of the electric current limiter.

10. The method according to any one of the preceding claims, comprising sampling measurements of an electric current through the semiconductor component to obtain electric current values.

11. The method according to any one of the preceding claims, wherein the controllable semiconductor component is a transistor (310).

12. A control unit configured to execute the method according to any one of the preceding claims.

13. An electric circuit (1,3) comprising:
a power supply input (101) for receiving electric power to be delivered to a load;
a current limiter (104) electrically connected between the power supply input (101) and the load (106), the current limiter comprises a controllable semiconductor component (112) connectable to the load as a current limiting component;
a control unit configured to:
sample measurements of a voltage across the controllable semiconductor component or across the current limiter at a sampling frequency,
calculate an energy dissipated in the controllable semiconductor component during a time duration based on the sampled voltage and an electric current value, and
control the controllable semiconductor component to allow for recovery time durations to maintain a temperature of the controllable semiconductor component below a predetermined limit.

14. The electric circuit according to claim 13, wherein the controllable semiconductor component is a transistor (310).

15. A computer program product comprising a computer readable medium having stored thereon computer program means for executing the method of any one of claims 1 to 11.
